# EUROPEAN PATENT APPLICATION

(11) **EP 2 840 375 A1**
(43) Date of publication of application: **25.02.2015**
(21) Application number: 13004107.2
(22) Date of filing: 19.08.2013
(51) Int. Cl.: G01L 19/14, G01D 11/00, G01D 11/24, H01L 23/16

(54) **Device with a micro- or nanoscale structure**

(71) Applicant: Sensirion AG, 8712 Stäfa (CH)
(72) Inventor: Mayer, Felix, CH-8712 Stäfa (CH)
(74) Representative: Toleti, Martin

(57) **Abstract**

A device with a micro- or nanoscale structure representing one or more of a mechanical structure, a sensing element, an active and/or passive electrical circuitry, comprises a component (1) containing the micro-or nanoscale structure (13), and a support (2) for the component (1). The support (2) contains a recess (23). The component (1) is arranged at least partly in the recess (23). An electrically conducting structure (3) is provided for bridging a gap (6) between the component (1) and the support (2).

## Description

### Technical Field

The present invention relates to a device with a micro- or nanoscale structure, the micro- or nanoscale structure representing one or more of a mechanical structure, a sensing element, an active and/or passive electrical circuitry.

### Background Art

In many devices comprising electronic and/or mechanical integrated structures including sensing elements these structures may be sensitive to stress. When such structures are applied to a front side of a substrate, the device may be arranged with its back side on a carrier and be electrically connected thereto by means of electrically conducting vias through the substrate.

It was observed that during mounting of such device to the carrier, and/or later on during operation, mechanical stress may be evoked and transmitted via solder balls to the substrate and specifically to stress sensitive structures of the device and may damage such structures.

### Disclosure of the Invention

The problem to be solved by the present invention is therefore to provide a device that is more resistant to mechanical stress induced by the mechanical link between a carrier and the device.

This problem is solved by a device with a micro- or nanoscale structure according to the features of claim 1. The micro- or nanoscale structure may contain one or more of a mechanical structure, a sensing element, an active and/or passive electrical circuitry.

The device comprises a component with a front side and a back side which component may in a preferred embodiment comprise a substrate for arranging the micro-or nanoscale structure onto and/or into. A top and a bottom side typically refer to opposite planes of the component or the substrate respectively, wherein in most instances the dimensions defining the front and back side i.e. the length and the width of the component - which in turn define a footprint of the component - exceed the height of the substrate. In a preferred embodiment, the height of the support may be as small as 150 micrometer or less, and the length and the width each may be as small as 1 millimeter or less. An exemplary substrate may be a semiconductor substrate, and specifically a silicon substrate, however, in other embodiments the substrate may be one of a glass, a ceramic or a plastic substrate.

A microscale structure in the context of the present application shall encompass a structure between 1 micrometer and 1000 micrometers, and in an embodiment between 1 micrometer and 100 micrometers, while a nanoscale structure shall encompass a structure between 1 nanometer and 1000 nanometers. In case the micro- or nanoscale structure comprises an electrical circuitry, such circuitry may comprise passive structures such as resistors which shall include resistors of electrical interconnections in the form of conducting paths such as aluminium or copper paths, and/or may include other passive structures such as capacitors, inductances, etc.. And/or the circuitry may include active structures, i.e. electronics, comprising, e.g. transistors, diodes, etc., or may represent an ASIC (application specific integrated circuit). In view of the scale of the circuitry, it is preferred that macroscale circuitry structures such a circuitry on a printed circuit board are excluded. The device may in addition or alternatively comprise a micro-or nanoscale mechanical structure such as a micromachine, a mechanical resonator, etc. which structure preferably is electrically connected by means of interconnections. In addition or alternatively, the device may include a MEMS (microelectromechanical) structure and/or a NEMS (nanoelectromechanical) structure. The device may in addition or alternatively comprise a micro- or nanoscale sensing element. In case the device includes a sensing element, the sensing element preferably is an element for sensing at least one of pressure, humidity, a chemical substance, a flow of a fluid including the flow of a liquid or the flow of a gas, temperature, stress, electromagnetic radiation such as light, or mechanical vibration including mechanical resonance.

Preferably, the micro- or nanoscale structure is integrated on the top side of the substrate by means of processes for manufacturing micro- or nanoscale structures, such as CMOS processes, MEMS processes, NEMS processes, etc.

A support is provided for holding the component. The support comprises a recess in which the component at least partially is arranged. Preferably, the component is arranged in the recess with its bottom side facing a bottom of the recess, such that the micro-or nanoscale structure is accessible from the outside.

An electrically conducting structure is provided preferably for electrically connecting the component to the support. The support preferably provides electrical interconnections for electrically connecting the electrically conducting structure to contact pads arranged at a back side of the support. In a preferred embodiment, one or more vias may be provided as part of the electrical interconnections in the support, wherein specifically each via may be connected by conducting paths to an assigned contact pad. A resulting electrically conductive pattern on the back side of the support may be denoted as redistribution layer and may, except for the contact pads, be covered by a lacquer or other protection means. Conductive means may be applied to the contact pads such as a conductive paste or solder balls. Hence, the micro- or nanoscale structure is preferably electrically connected to the outside world, i.e. to circuits outside the device.

A gap is provided between the component and at least a side wall of the support which side wall code-termines the recess. The electrically conducting structure bridges the gap. Hence, the component may have a certain lateral leeway subject to the stiffness of the electrically conducting structure.

By means of such device, mechanical stress that becomes induced into the support of the device via the solder balls, for example, either during mounting of the device to a carrier, and/or later on during operation, may not or negligible be forwarded to the sensitive micro- or nanoscale structure of the component since the electrically conducting structure which preferably is the sole solid mechanical connection between the support and the component prevents from doing so. In a preferred embodiment, the electrically conducting structure does not represent a tight mechanical connection between the component and the support but rather allows for a relative movement between the component and the support, such as is the case with a bond wire. In another preferred embodiment the layout of the electrically conducting structure makes the component remaining movable relative to the support, at least at a certain tolerance. Summarizing, the stress sensitive micro- or nanoscale structure in the component is mechanically decoupled from the support.

In a preferred embodiment, the component is suspended from the support solely by means of the electrically conducting structure which may comprise one or more bond wires, tape automated bonding elements or similar. In this case, the component does not touch the support such that the gap further extends between a bottom of the recess and the component. For this purpose the electrically conducting structure and/or the component are designed such that the electrically conducting structure is capable of holding the component on its own. Whenever the component is a small, light die, for example, and preferably is represented by a single chip such as a semiconductor chip with a sensing element and electrical circuitry integrated thereon as the micro- and/or nanoscale structure which electrical circuitry may process signals of the sensing element during operation, a conventional electrically conducting element such as a bond wire may be sufficient to hold the component without further solid interconnections between the component and the support. In another embodiment however, the component may be allowed to touch one or more walls defining the recess. For example, the component may rest on the bottom of the recess, however, without being fixed thereto. Still, it is preferred that the component is not restrained in the recess which preferably is achieved by designing a footprint of the component smaller than a footprint of the recess. In other words, it is preferred that the electrically conducting structure bridges a gap between the component and the support.

In another embodiment which is applicable to both of the above alternatives, a gel may be provided in the recess for filling at least a part of a gap between the component and the support. The gel is not a solid element and as such does not transmit mechanical stress but on the other hand may prevent the substrate and/or the electrically conducting structure from damages resulting from mechanical shocks or vibrations.

It is preferred, that a top surface of the component and a top surface of the support are arranged in a common plane. This helps applying the electrically conducting structure.

Preferably, the electrically conducting structure contains at least two electrically conducting elements connecting opposite sides of a footprint of the component to the support. This improves a balanced suspension of the component. In an even more sophisticated embodiment, the component has a rectangular footprint containing four sides, and the electrically conducting structure contains four electrically conducting elements each connecting a different side of the component to the support. Preferably, each of the electrically conducting elements bridges the gap between the component and the support not via the shortest path but is inclined with respect to an axis perpendicular to a side surface of the component in a horizontal plane defined by the footprint of the component. This may allow a certain rotation of the component around its vertical axis against the support which may be desired when stress is induced into the support. In another preferred embodiment, the electrically conducting structure includes a spring section for allowing a rotation of the component around its vertical axis and at the same time balancing it.

In another preferred embodiment, the device comprises a cap arranged on the support for protecting the component. Preferably, the cap contains at least one spacer extending from the cap into an interior defined by the cap and the support and/or the component for preventing the component to move towards a ceiling of the cap beyond a maximum deflection.

Other advantageous embodiments are listed in the dependent claims as well as in the description below.

### Brief Description of the Drawings

Embodiments of the present invention, aspects and advantages will become apparent from the following detailed description thereof. Such description makes reference to the annexed drawings, wherein the figures show:
FIGs 1 to 6 each shows a device with a micro-or nanoscale structure according to an embodiment of the present invention in a lateral cut, and
FIGs 7 and 8 each shows a top view on a device with a micro- or nanoscale structure according to an embodiment of the present invention.

### Modes for Carrying Out the Invention

Same elements are referred to by the same reference signs across the figures.

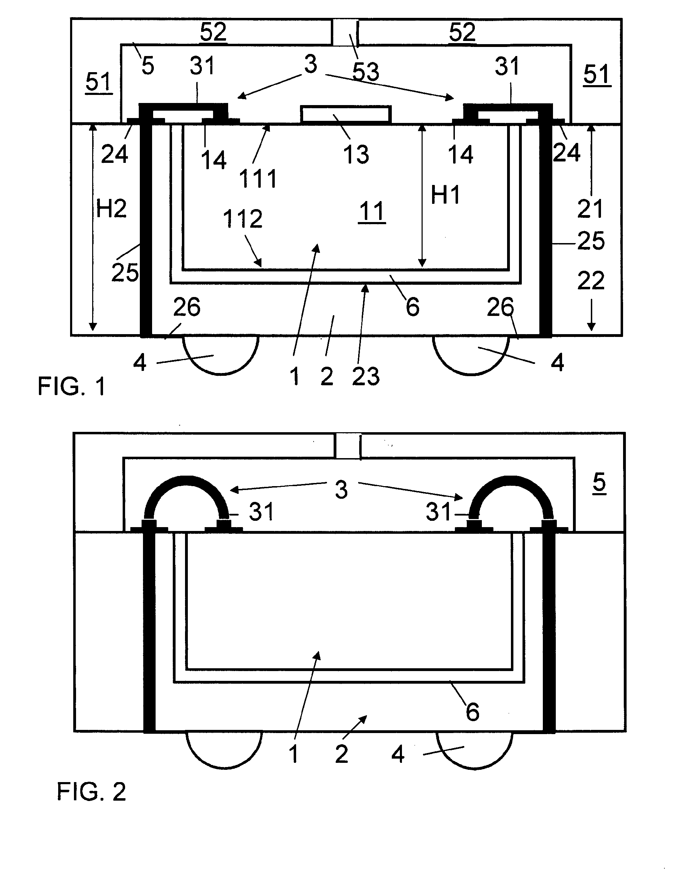

Figure 1 schematically illustrates a device with a micro- or nanoscale structure 13 according to an embodiment of the present invention. This structure 13 is not depicted in many of the following Figures for illustration purposes, but may still be assumed there. The device comprises a component 1 in form of a single chip arranged in a recess 23 of a support 2. The component 1 comprises a semiconductor substrate 11 with a rectangular footprint and with a height H1 in vertical direction. Other shapes of the footprint may be applied if desired, such as a circular footprint, for example. The micro- or nanoscale structure 13 is arranged at a top side 111 of the component 1. In one example, the micro- or nanoscale structure 13 may include a sensing element and electronic circuitry for processing a sensor signal of the sensing element 13. The micro- or nanoscale structure 13 may be fabricated by means of MEMS and/or CMOS processing for example. The top side 111 of the substrate 11 may be covered by a passivation layer (not shown) for protecting the electronic circuitry and possibly the sensing element.

The support 2 preferably is made from a single piece of material, such as ceramics, silicon or plastics, for example, and has a top side 21 and a bottom side 22 and a height H2. The recess 23 is formed into the top side 21 of the support 2. Contact pads arranged at the bottom side 22 may carry solder bumps/balls 4 or other means for electrically connecting the device to a carrier such as a printed circuit board. Electrically conducting vias 25 are provided in through holes leading through the support 2 from its top side 21 to its bottom side 22. Preferably, the through holes in the support 2 may be manufactured by etching or laser drilling. The through holes may then be filled with a conductive material such as aluminium. In one embodiment, a through hole for a via may completely be filled by the conductive material while in another embodiment only the walls of the through hole may be covered by the conductive material.

On the bottom side 22 of the support 2, the vias 25 are electrically connected to the contact pads carrying the solder balls 4 by means of conductors 26. On the top side 21 of the support 2, the vias 25 are electrically connected to contact pads 24.

Electrically conducting elements 31 are arranged between the contact pads 24 of the support 2 and contact pads 14 of the component 1. An entirety of the electrically conducting elements 31 is denoted as electrically conducting structure 3. In the present embodiment, each electrically conducting element 31 is a tape automated bonding (TAB) element. In tape automated bonding electrically conducting strips are stored on a foil and can be detached therefrom directly to the destination. During the bonding process step, the component 1 may preferably be fixated by a glue or a polymer or a resist which may later on be removed again. Overall, an electrical path may be implemented from/to the micro-and/or the nanoscale structure 13 to/from the solder balls 4.

The device can be surface mounted onto a carrier such as a printed circuit board via the solder balls 4. Especially, when the micro- or nanoscale structure 13 includes a sensing element, such set-up of the device is preferred since the sensing element is directed towards the ambience and not towards the carrier.

In the present embodiment, the component 1 actually is suspended from the support 2 solely by means of the electrically conducting structure 3. This means that the electrically conducting structure 3 in this embodiment not only serves for electrically connecting the component 1 to the support 2 but also serves for mechanically holding the component 1 in a desired position, i.e. a suspended position in which the component 1 does not touch the support 2. The electrically conducting structure 3 holds the component 1 such that a gap 6 is provided between the support 2 and the component 1 all around the component 1. Given that the component 1 preferably is lightweight and of small size, e.g. when it contains a die of semiconducting material, the electrically conducting structure 3 may be sufficiently strong and stiff for holding the component 1 in a suspended state without any further means. Hence, the electrically conducting structure 3 constitutes the sole solid connection between the component 1 and the support 2.

Whenever stress is induced into the support 2 via the solder balls 4 - either during mounting the device to the carrier, or later on during operation because of the carrier being bent - the stress may not be forwarded to the stress sensitive micro- or nanoscale structure 13 of the component 1 since the stress sensitive structure 13 is mechanically decoupled from the support 2 owed to the electrically conducting structure 3 which is the only solid connection between the component 1 and the support 2. The electrically conducting structure 3 represents a flexible means that allows for a relative movement between the component 1 and the support 2 in the horizontal plane, at least at a certain tolerance, which makes the component 1 less prone to stress. The electrically conducting structure 3 serves as a bottleneck for stress to migrate into the substrate 11 and into the sensitive structure 13. Hence, by limiting the solid mechanical connection between the component 1 and the support 2 to the electrically conducting structure 3, stress migration into the substrate 11 and thus into the sensitive structure 13 can significantly be reduced.

The component 1 in Figure 1 is protected by a cap 5 including side walls 51 and a ceiling 52 in which ceiling 52 a through hole 53 is arranged for allowing measuring an ambient variable in case the structure 13 contains a sensing element. The cap 5 preferably is mounted to the support 2 by bonding the cap 5 thereon. The cap 5 may be made from plastics or ceramics, for example. The cap 5 may be provided on wafer-level and be attached to a support wafer, too. Thereafter, the devices may be separated from each other.

In the following Figures 2 to 6, further devices according to embodiments of the present invention are shown in a lateral cut each. For illustration purposes many of the reference signs introduced in Figure 1 are omitted. In the description it is solely referred to differences with respect to the device of Figure 1.

In the device according to Figure 2, the electrically conducting elements 31 are now embodied as bonding wires instead of tape automated bonding elements. Conventional bonding techniques may be applied for electrically and possibly mechanically connecting the component 1 to the support 2 by means of the bonding wires.

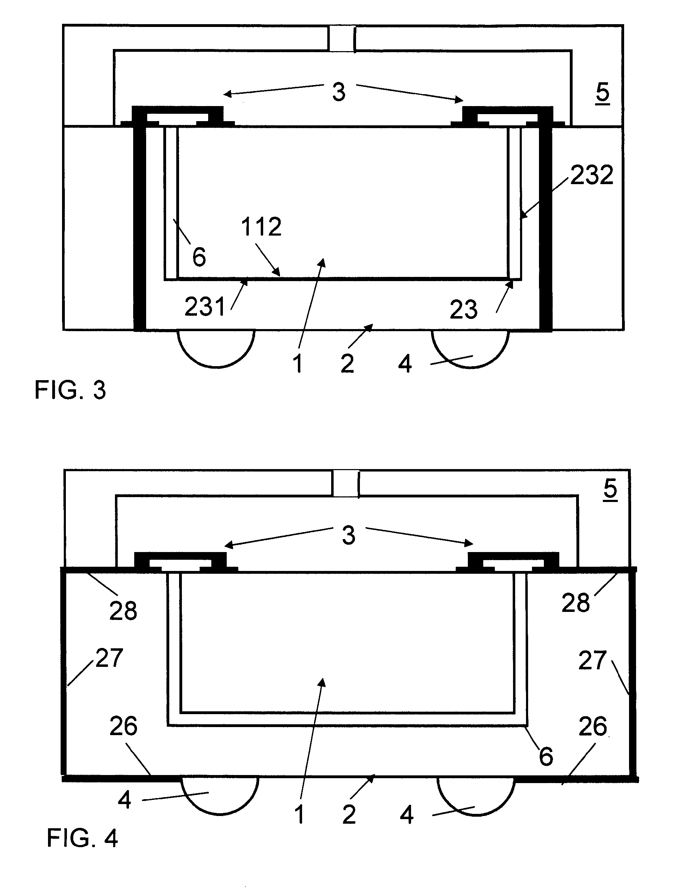

In the device according to Figure 3, the component 1 no longer is suspended from the support 2 but rests on a bottom 231 of the recess 23 in the support 2. Here, the component 1, the recess 23 and/or the electrically conducting structure 3 are dimensioned and/or designed such that the component 1 finally rests on the bottom 231 of the recess 23. However, the component 1 is not fixed to the bottom of the recess 23 but only rests thereon. The gap 6 is limited to a space between a side wall 232 of the recess 23 and the component 1.

The device of Figure 4 no longer comprises vias extending vertically through the support 2. Instead, outer side walls of the support contain conducting paths 27 for electrically connecting conductors 28 on the top side 21 of the support 2 to conductors 26 arranged on the bottom side 22 of the support. There may be scenarios in which the manufacturing of vias may be cumbersome such that the present alternative may be preferred. In this embodiment, the outside conducting paths 27 may be protected, e.g. by means of a passivation layer.

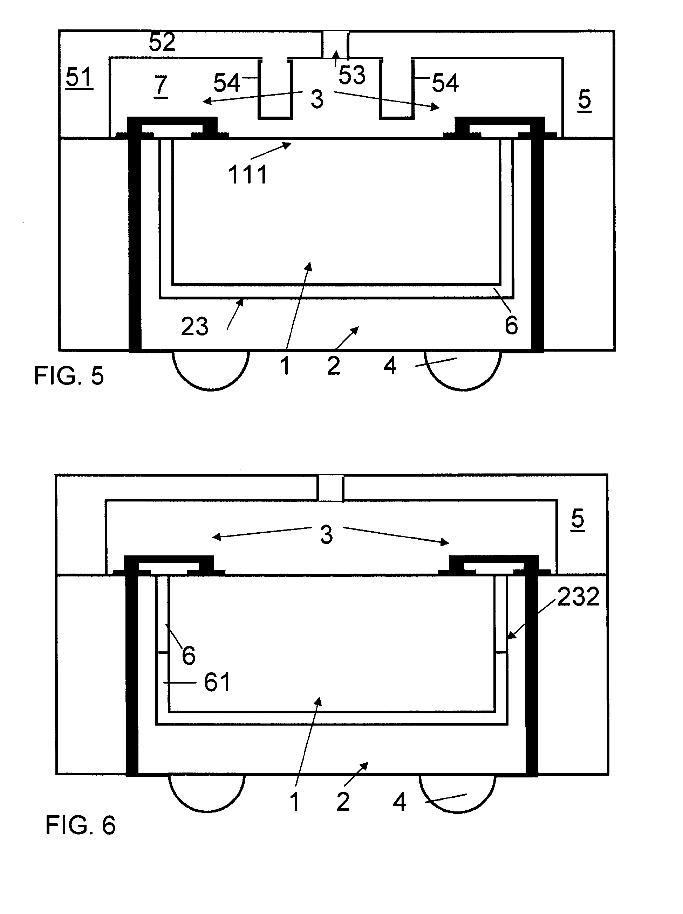

In Figure 5, the cap 5 is modified with respect to Figure 1. The cap 5 now contains one or more spacers 54 extending from the ceiling 52 into an interior 7 of the device which interior is defined by the cap 5 and the support 2 and/or the component 1. The one or more spacers 54 prevent the component 1 from being lifted excessively, e.g. during handling of the device. Subject to the material characteristics and the shape of the electrically conducting structure 3, which generally may be a metallic structure, for example, and given that the component 1 is not fixed to the recess 23, the component 1 may be movable at least in a vertical direction and emerge out of the recess 23. The one or more spacers 54 may limit such vertical movement. In the present example, the spacers 54 may be embodied as multiple individual protrusions preferably made integrally with the rest of the cap 5. Or, the spacer 54 may be a circular spacer 54 around the through hole 53. By limiting the vertical deflection of the component 1, the component 1 itself and the electrically conducting structure 3 may be protected from damage.

In Figure 6, the gap 6 is not filled by a gas such as air but is partly filled by a liquid or a semi-liquid material such as a gel 61. The gel 61 may be preferred in that there may be no further need for retaining means. The gel 61 may serve to prevent the component 1 from mechanical impact when bumping at the walls of the recess 23 or the cap 5. The gel 61 on the other hand is not a solid which would transfer stress from the support 2 to the component 1. The gel 61 may not only be applied to a device according to Figure 6, wherein the component 1 does not touch the support 2, but also to a device according to Figure 4 wherein the component 1 rests on the bottom 231 of the recess 23. In the latter embodiment, the side gaps between a sidewall 232 of the support 2 and the component 1 may at least be partly filled by the liquid or the semi-liquid. The gel 61 may be of a viscosity such that it does not leak out of the gap 6.

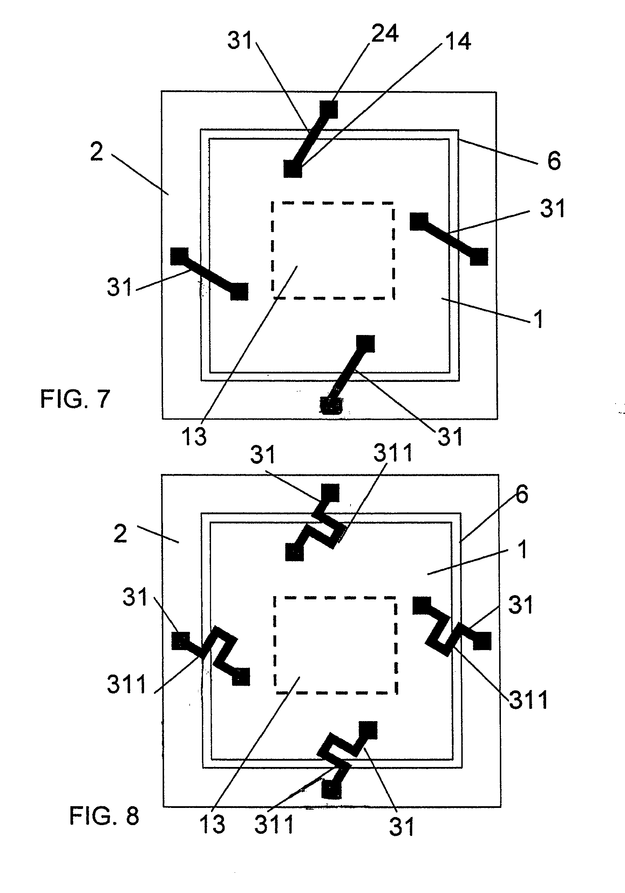

FIG. 7 illustrates a top view on a device with a micro- or nanoscale structure according to an embodiment of the present invention, the device lacking cap or the cap being removed. The dashed line indicates a micro- or nanoscale structure 13 integrated into/onto a component 1. The component 1 preferably is a die with a rectangular footprint. So is the footprint of the support 2 and of the recess 23 in the support 2. The component 1 is arranged in the recess 23 of the support 2 such that a gap 6 is formed between the sides of the component 1 and the walls defining the recess 23. Since the component 1 has a rectangular, and specifically a quadratic footprint, it is preferred that the component 1 is connected to the support 2 at each side of the component by means of an electrically conducting element 31. Each electrically conducting element 31 bridges the gap 6 between the component 1 and the support 2. Hence, the present component 1 is suspended at four points, making the suspension mechanically reliable. Generally, a number n of electrically conducting elements 31 may be provided with 2 ≤ n ≤ 6. It is not required that each electrically conducting element 31 is used as an electrical connection in operation. An electrically conducting element 31 may not even be connected to any electrically conducting structure on either the component 1 or the support 2 and as such may solely be used element for suspending the component 1.

The top view on a device according to an embodiment of the present invention according to Figure 8 differs from the device of Figure 7 in that the electrically conducting elements 31 each have a spring section 311. The spring sections 311 serve as a spring when the component 1 rotates versus the support around a vertical axis. By means of the spring sections 311 in each electrically conducting element, such rotation can be limited. Hence, the spring sections 311 serve as means counteracting torques of the component.

## Claims

1. Device with a micro- and/or nanoscale structure representing one or more of a mechanical structure, a sensing element, an active and/or passive electrical circuitry, the device comprising
- a component (1) containing the micro-and/or nanoscale structure (13),
- a support (2) for the component (1), the support (2) containing a recess (23) and the component (1) being at least partly arranged in the recess (23),
- a gap (6) between the component (1) and at least a side wall (232) of the support (2) codetermining the recess (23), and
- an electrically conducting structure (3) bridging the gap (6).

2. Device according to claim 1,
wherein the electrically conducting structure (3) is the sole solid connection between the component (1) and the support (2).

3. Device according to claim 1 or claim 2,
wherein the component (1) is suspended from the support (2) by means of the electrically conducting structure (3), and
wherein the gap (6) extends between the component (1) and a bottom (231) of the recess (23) in the suspended state.

4. Device according to claim 1 or claim 2,
wherein the component (1) rests on a bottom (231) of the recess (23) without being fixed thereto.

5. Device according to any one of the preceding claims,
comprising a gel (61) in the recess (23) for filling at least a part of the gap (6) between the component (1) and the support (2).

6. Device according to any one of the preceding claims,
wherein the component (1) comprises a single chip containing a substrate (11), and in particular a semiconductor substrate,
wherein the micro- or nanoscale structure (13) is arranged on the substrate (11) and/or is integrated into the substrate (11), and
wherein the micro- and/or nanoscale structure includes a sensing element and active and/or passive electrical circuitry.

7. Device according to any one of the preceding claims,
wherein the component (1) comprises a top side (111) and a bottom side (112) opposite to the top side (111),
wherein the micro- or nanoscale structure (13) is arranged on the top side (111) of the substrate (11) and/or is integrated into the substrate (11) at its top side (111),
wherein the component (1) is arranged in the recess (23) of the support (2) with its bottom side (112) facing a bottom (231) of the recess (23).

8. Device according to claim 7,
wherein the support (2) contains a top side (21),
wherein the recess (23) extends from the top side (21) into the support (2), and
wherein the top side (111) of the component (1) and the top side (21) of the support (2) are arranged in a common plane.

9. Device according to any one of the preceding claims,
wherein the electrically conducting structure (3) contains at least two electrically conducting elements (31) connecting opposite sides of a footprint of the component (1) to the support (2).

10. Device according to claim 9,
wherein the electrically conducting element (31) is one of
- a bond wire;
- a tape automated bonding structure.

11. Device according to any one of the preceding claims,
wherein the component (1) has a rectangular footprint containing four sides,
wherein the electrically conducting structure (3) contains four electrically conducting elements (31) each connecting a different side of the component (1) to the support (2).

12. Device according to any one of the preceding claims,
wherein the electrically conducting structure (3) includes a spring section (311).

13. Device according to any one of the preceding claims,
comprising a cap (5) arranged on the support (2) for protecting the component (1).

14. Device according to claim 13,
wherein the cap (5) contains at least one spacer (54) extending from the cap (5) into an interior (7) defined by the cap (5) and the support (2) and/or the component (1) for preventing the component (1) to move towards a ceiling (52) of the cap (5) beyond a maximum deflection.

15. Device according to any one of the preceding claims,
wherein the support (2) comprises one or more vias (25) extending through the support (2) for providing an electrical connection between a top side (21) and a bottom side (22) of the support (2).
